# EUROPEAN PATENT APPLICATION

(11) **EP 0 808 915 A2**
(43) Date of publication of application: **26.11.1997**
(21) Application number: 97108254.0
(22) Date of filing: 21.05.1997
(51) Int. Cl.: C23C 14/34, C23C 16/44, C23C 14/58, C23C 16/56, C23C 14/54, C23C 16/52

(54) **Chemical vapor deposition and sputtering method and apparatus**

(30) Priority: 23.05.1996 US 652860
(71) Applicant: APPLIED MATERIALS, INC., Santa Clara, California 95050 (US)
(72) Inventor: Littau, Karl A., Palo Alto, California 94303 (US)
(74) Representative: Kirschner, Klaus Dieter, Dipl.-Phys.

(57) **Abstract**

An apparatus (35) for depositing material on a substrate (20) by chemical vapor deposition and sputtering is described. The apparatus (35) comprises a deposition chamber (40) having a support (65) for supporting the substrate (20) in the chamber. A sputtering target (60) facing the substrate (20) in the chamber (40), has a sputtering surface comprising sputtering material. A plasma generator in the chamber (40) is used to generate a plasma from process gas introduced into the chamber. A gas distributor (55) is used to distribute process gas in the chamber (40), the process gas selected from the group consisting of (i) deposition gas capable of depositing a CVD layer on the substrate (20) by chemical vapor deposition, or (ii) sputtering gas capable of forming a plasma for sputtering the target (60) to deposit a sputtered layer on the substrate. Optionally, the apparatus (35) can also include a heater (80) for heating the substrate (20) to diffuse the CVD and sputtered layers into one another to form a substantially homogeneous diffusion mixture of the deposited and sputtered layers. The apparatus (35) is particularly useful for depositing multicomponent alloys on the substrate (20).

## Description

This invention relates to a method and apparatus for depositing material on a substrate by chemical vapor deposition and sputtering processes.

In integrated circuit fabrication, electrically conductive features, such as metal interconnect lines and vias, are used to electrically connect the semiconductor devices formed on substrates. The conductive features are typically formed by (i) depositing layers of different materials on the substrate, including diffusion barrier, electrical conductor, and antireflective layers, (ii) forming patterned resist layers on the deposited layers, and (iii) etching the unprotected portions of the deposited layers to form the electrically conductive features. An electrical insulator layer, such as silicon dioxide, is deposited over the features to electrically isolate the features from one another. Contact holes or vias are etched through the insulator layer to expose underlying electrically conductive features or semiconductor devices. The contact holes or vias are filled with electrical conductor material to form electrically conductive interconnects that interconnect the conductive features and devices formed on the substrate.

Conventional sputtering processes or chemical vapor deposition processes are used to deposit the electrical conductor material on the substrate to form the interconnect lines or fill the contact holes and vias. One problem with conventional processes arises because the electrical conductor material typically comprises multicomponent alloys containing 95 to 98 wt% aluminum, 1 to 3 wt% silicon, and 0.5 to 1 wt% copper. Copper is added to prevent electromigration of aluminum atoms to extend the lifetime of the conductive features. Silicon is added to reduce inter-diffusion of atoms between the aluminum layer and the underlying silicon substrate.

Generally, the multicomponent alloys are deposited by physical vapor deposition techniques, such as sputtering and electron-beam evaporation, using a target material made from aluminum, copper, and silicon. However, conventional physical vapor deposition methods such as sputtering provide line-of-sight deposition in which material sputtered off the target by energetic plasma ions travels to the substrate in a relatively straight-line path to deposit on those portions of the substrate within sight of the target. This results in deposition of a non-conformal layer with varying thickness and composition, making it difficult to uniformly deposit material on substrates that have an irregular surface topology, and particularly difficult to uniformly fill high aspect ratio contact holes or vias that have a depth to diameter ratio exceeding 1.

The thickness variability of the layers deposited by sputtering can be reduced by heating the substrate above the melting temperature of the deposited aluminum alloy to melt and reflow the alloy within the contact hole or via. However, when molten aluminum solidifies, the alloy shrinks at low surface tension contact areas, resulting in non-uniform and irregular filling of the contact hole or via. Also, because the melting temperature of aluminum is relatively high at about 500°C, the use of reflow techniques is limited to substrates that are not damaged by these high temperatures. The high processing temperatures can cause excessive diffusion of dopant material within the features and devices formed on the substrate, or even melt low melting point oxide layers, such as boron phosphorous silicon dioxide glass (BPSG). Also, many photosensitive resists that are used to form patterned features on the substrate degrade at temperatures above about 175°C, losing their ability to be exposed and developed.

The multicomponent alloys can also be deposited by chemical vapor deposition (CVD) processes which provide more conformal deposition, and more uniform filling of the contact holes and vias. However, it is difficult to deposit multicomponent alloys by chemical vapor deposition, because the precursor gases for different alloy components often react with one another to form undesirable byproducts. For example, many aluminum precursor gases, such as AlH₃, are reducing agents; and copper precursor gases, such as CuHFAC (a copper and fluorine based precursor), are often oxidizing agents. Mixing the oxidizing and reducing agents can result in formation of undesirable reaction byproducts. The inability to transport or mix the copper and aluminum precursor gases without decomposition or reaction of the gases limits the use of such CVD methods. It is also difficult to find suitable chemical vapor deposition precursor gases for materials such as copper. While traditional precursor gases for deposition of metal include metal alkyls and carbonyls, copper carbonyl is unstable, and copper alkyls are often polymers that are nonvolatile and cannot be used as precursor gases. Also, conventional CVD methods for depositing copper often deposit copper that is contaminated with carbon and/or oxygen which imparts high electrical resistivity to the deposited copper.

Sequential CVD processes have also been used to sequentially deposit aluminum and copper layers on the substrate followed by heat treatment of the aluminum/copper multilayer to diffuse the copper and aluminum into one another. After deposition of the copper layer using a copper precursor, the deposition chamber is pumped down to exhaust all the copper precursor gas from the chamber, and aluminum precursor gas is introduced into the chamber to deposit aluminum on the copper layer. Because the copper and aluminum precursor gases are highly reactive with one another, the pump-down step must exhaust all the residual copper precursor gas in the chamber. The pump-down step takes considerable time to perform, thereby reducing processing throughput, and consequently, limiting commercial application of the sequential CVD process.

Yet another method for depositing multicomponent alloys uses separate CVD and sputtering process chambers. In this method, aluminum is deposited on the substrate by chemical vapor deposition in a CVD process chamber; and thereafter, the substrate is transferred to a sputtering chamber for sputtering a second layer of aluminum and copper on the substrate. The multiple layers are then heat treated to diffuse the copper and aluminum into one another. The multi-chamber process has several disadvantages. First, exposure of the aluminum layer to the atmosphere during transfer of the substrate from one chamber to another can result in formation of an aluminum oxide film that acts as a diffusion barrier and prevents diffusion of the copper and aluminum during the subsequent heat treatment step. Also, the additional transport step between the two chambers can damage or contaminant the substrate reducing the yield of the substrate. Furthermore, use of multiple chambers reduces process throughput due to the time it takes for the substrate to be transferred from the CVD chamber to the sputtering chamber.

It is an object of the invention to provide a method and an apparatus for the chemical vapor deposition and sputtering capable of efficiently depositing different materials on a substrate to form a multicomponent alloy layer.

A preferred embodiment of the present invention provides an apparatus capable of depositing material on a substrate by chemical vapor deposition and sputtering processes performed in a single process chamber without transferring the substrate from one chamber to another. The apparatus comprises a chamber having a support for supporting the substrate therein. A sputtering target facing the substrate in the chamber, has a sputtering surface comprising sputtering material. A gas distributor is used to distribute process gas in the chamber, the process gas selected from the group consisting of (i) deposition gas capable of depositing CVD material on the substrate by chemical vapor deposition, or (ii) sputtering gas capable of forming a plasma for sputtering the target to deposit sputtered material on the substrate. A plasma generator is used to generate a plasma from the process gas introduced into the chamber.

Preferably, the gas distributor and sputtering target form a unitary structure comprising (a) a housing for holding process gas therein; and (b) a sputtering target plate on the housing, the target plate comprising (i) a sputtering surface thereon, and (ii) holes extending through the target plate and sputtering surface for distributing process gas held in the housing into the chamber. The housing is electrically isolated from the process chamber so that the target plate of the housing can be electrically biased with respect to the chamber to form an electric field that generates a plasma for sputtering material from the sputtering surface of the target plate. The sputtering surface can comprise a layer of sputtering material deposited on the target plate, or the target plate can be made of the sputtering material.

Optionally, the apparatus can also include a heater for heating the substrate to temperatures sufficiently high to diffuse the CVD and sputtered layers into one another to form a substantially homogeneous diffusion mixture of the CVD and sputtered materials. This version of the apparatus is particularly useful for depositing multicomponent layers on a substrate in a single deposition chamber, using successive CVD, sputtering, and heat treatment steps, without transferring the substrate from chamber to chamber.

To use the apparatus, a substrate is placed in a process zone comprising (i) a gas distributor for distributing process gas in the process zone, and (ii) a sputtering target facing the substrate. In a CVD process stage, deposition gas is introduced into the process zone, and the process zone is maintained at process conditions suitable for depositing a first material on the substrate by decomposition of the deposition gas. In a sputtering process stage, performed before or after the CVD process stage, sputtering gas is introduced into the process zone, and a plasma is formed from the sputtering gas to deposit a second material on the substrate by sputtering the target.

The apparatus is also useful for depositing a sputtered nucleation layer on the substrate that enhances the uniformity of deposition of a chemical vapor deposition layer. In a sputtering process stage, sputtering gas is introduced in the process zone, and a plasma is formed from the sputtering gas to deposit a sputtered nucleation layer on the substrate by sputtering the target. Thereafter, in a CVD process stage, deposition gas is introduced into the process zone, and the process zone is maintained at process conditions suitable to deposit a chemically vapor deposited layer on the sputtered nucleation layer. The sputtered nucleation layer is deposited to a sufficient thickness to enhance the deposition uniformity of the chemically vapor deposited layer, and preferably, the ratio of the thickness of the sputtered nucleation layer to that of the chemically vapor deposited layer is from about 0.1:100 to about 1:100.

In another aspect, a preferred embodiment of the present invention comprises a computer program product for operating a process chamber to deposit material on a substrate by chemical vapor deposition and sputtering processes. The computer program product comprising a computer usable medium having computer readable program code means embodied in the medium. The computer program code comprises a substrate positioning subroutine for positioning the substrate in the process chamber. A process gas control subroutine is provided for operating the process chamber in (i) a CVD deposition mode in which deposition gas is introduced into process chamber, and (ii) a sputtering gas mode in which sputtering gas is introduced into the process chamber. A plasma control subroutine is used to operate the process chamber in (i) a CVD plasma mode in which a plasma is formed from the deposition gas to deposit CVD material on the substrate by chemical vapor deposition, and (ii) a sputtering plasma mode in which a plasma is formed from sputtering gas to deposit sputtered material on the substrate by sputtering the target.

Further preferred embodiments of the invention are claimed in the appended claims and subclaims.

The embodiments of the invention have the advantage that the materials can be conformally deposited on the substrate, and that uniform filling of the high aspect ratio contact holes and vias on the substrate is provided. Furthermore, the multicomponent alloy layers can have a uniform and homogeneous composition through the thickness of the layer.

Embodiments of invention will now be described with reference to accompanying drawings wherein:
Figure 1 is a schematic view of a chemical vapor deposition and sputtering apparatus of the present invention;
Figure 2 is a perspective exploded view of a unitary structure capable of serving as a gas distributor and a sputtering target;
Figure 3 is a simplified block diagram showing the hierarchical control structure of a computer program used to implement the present invention;
Figures 4a to 4e are schematic cross-sectional views of a substrate processed according to the present invention; and
Figures 5a to 5c are secondary ion mass spectrographs of the mass concentration of copper and aluminum in the layers deposited on the substrate, after heat treatment of the substrate at different temperatures.

The present invention is directed to an apparatus and method for sequentially depositing different materials on a substrate, by chemical vapor deposition (CVD) and sputtering processes that are performed in a single deposition chamber. The substrate 20 can include glass, polymer, metal, or semiconductor substrates, including for example, monocrystalline silicon, gallium arsenide, or polysilicon substrates. The method is particularly suitable for depositing layers of aluminum alloys on the substrate 20, such as for example alloys of aluminum, copper, and optionally silicon, which are etched to form electrical interconnects 25 that connect devices formed on semiconductor substrates 20. The aluminum alloys are also deposited in holes 30, commonly known as contact holes or vias, etched though insulative oxide layers (such as silicon oxide, phosphosilicate glass (PSG), or borophosphosilicate glass (BPSG) layers) to form electrically conductive interconnects 25.

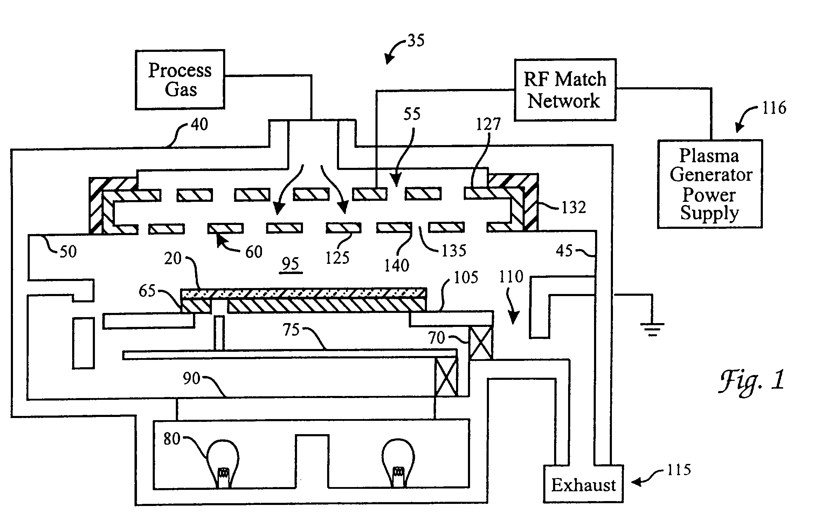

A schematic of a processing apparatus 35 that illustrates the present invention, is shown in Figure 1. The particular embodiment of the apparatus 35 shown herein, is suitable for processing planar substrates 20, such as semiconductor substrates, is provided only to illustrate the invention, and should not be used to limit the scope of the invention. The apparatus 35 typically comprises a cluster of interconnected process chambers, for example, etching, deposition, and implantation chambers, and includes at least one enclosed deposition chamber 40 having surrounding sidewalls 45 and a ceiling 50. A process gas distributor 55 is provided for distributing process gas into the chamber 40, such as for example, deposition gas capable of decomposing to deposit CVD material on the substrate by chemical vapor deposition, or sputtering gas for sputtering a target to deposit sputtered material onto the substrate 20. Mass flow controllers and air operated valves are used to control the flow of process gas into the deposition chamber 40.

The deposition chamber 40 also comprises a sputtering target 60 facing the substrate, the target having a sputtering surface comprising sputtering material. The sputtering target 60 is electrically isolated from the chamber, so that the target can be electrically biased with respect to the chamber, to form an electric field that generates a plasma for sputtering material from the sputtering surface of the target. The process gas distributor 55 and sputtering target 60 can be fabricated as separate structures, or more preferably can be fabricated as a unitary structure, as described in more detail below.

A support 65 is provided for supporting the substrate in the deposition chamber 40. The substrate 20 is introduced into the chamber 40 through a substrate loading inlet in the sidewall 45 of the chamber 40 and placed on the support 65. The support 65 can be lifted or lowered by support lift bellows 70 so that the gap between the substrate 20, gas distributor 55, and sputtering target 60 can be adjusted. A lift finger assembly 75 comprising lift fingers that are inserted through holes in the support 65 can be used to lift and lower the substrate 20 onto the support to facilitate transport of the substrate 20 into and out of the chamber 40. A heater 80 is provided for heating the substrate 20 during thermally activated processes, such as chemical vapor deposition processes. The temperature of the substrate 20 is generally estimated from the temperature of the support 65 that is measured using a thermocouple located in the support 65. The heater 80 can comprise a resistor (not shown) embedded in the support 65 for resistively heating the substrate 20, or heating lamps underneath a quartz window 90 (as shown). The heater 80 can also be used to heat the substrate 20 to temperatures sufficiently high to diffuse layers of CVD and sputtered materials deposited on the substrate 20 into one another to form a homogeneous diffusion mixture.

The substrate 20 is processed in a process zone 95 above a horizontal perforated barrier plate 105. The barrier plate 105 has exhaust holes 110 which are in fluid communication with an exhaust system 115 for exhausting spent process gas from the chamber 40. A typical exhaust system 115 comprises a rotary vane vacuum pump (not shown) capable of achieving a minimum vacuum of about 10 mTorr, and optionally a scrubber system for scrubbing byproduct gases. The pressure in the chamber 40 is sensed at the side of the substrate 20, and is controlled by adjusting a throttle valve in the exhaust system 115.

A plasma generator 116 is provided for generating a plasma in the process zone 95 of the chamber 40. The plasma can be used to sputter the target 60 for depositing sputtered material on the substrate, and is also useful for plasma enhanced chemical vapor deposition processes. The plasma generator 116 can generate a plasma (i) inductively by applying an RF current to an inductor coil encircling the deposition chamber (not shown), (ii) capacitively by applying an RF current to process electrodes in the chamber, or (iii) both inductively and capacitively. In sputtering processes, the plasma is typically generated by applying a DC or RF voltage at a power level of from about 100 to about 1000 Watts, and more typically from 100 to 500 Watts, to the electrically isolated sputtering target 60 which serves as an electrode, and by electrically grounding the support 65 and/or the chamber sidewalls 45. Alternatively, a DC or RF current at a power level of from about 750 Watts to about 2000 Watts can be applied to an inductor coil (not shown) to inductively couple energy into the deposition chamber to generate the plasma in the process zone 95. When an RF current is used, the frequency of the RF current is typically from about 400 KHz to about 16 MHz, and more typically about 13.56 MHz. Optionally, a gas containment or plasma focus ring (not shown), typically made of aluminum oxide or quartz, can be used to contain the flow of process gas or plasma, around the substrate 20.

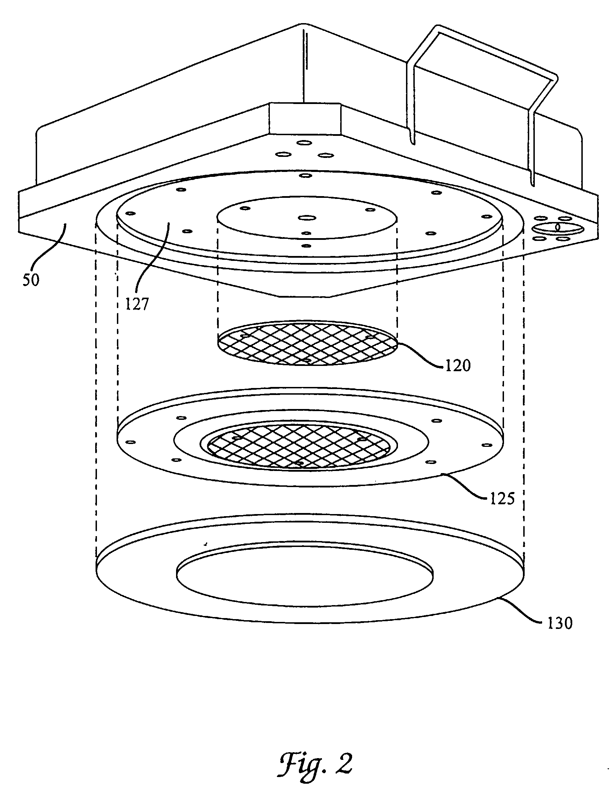

In one version of the apparatus 35, the gas distributor 55, and sputter target 60 comprise separate structures that are positioned in the chamber 40 to achieve an optimal combination of sputtering and CVD deposition properties. For example, the gas distributor 55 can be mounted above the substrate (as shown), or peripherally about the substrate 20 (not shown) to introduce process gas to the peripheral edge of the substrate. In a preferred configuration, the gas distributor 55 comprises an assembly of components, as shown in Figure 2, that include a perforated blocker plate 120 and a "showerhead" diffuser 125 fastened to a housing 127 on the chamber ceiling 50. Optionally, a shield ring 130 can be detachably clamped over the diffuser 125 to shield the gas distributor 55 from the plasma in the chamber 40.

The sputtering target 60 is positioned facing the substrate 20, and electrically isolated from the deposition chamber 40 by an electrical insulator 132, so that the target 60 can serve as a process electrode for generating a plasma that sputters material from the target 60. Typically, an RF bias current is applied to the sputtering target 60, and the sidewalls 45 of the chamber and/or the support 65 are electrically grounded to form an electric field in the chamber 40 that ionizes the sputtering gas to form a sputtering plasma that sputters the target 60. The sputtering target 60 can comprises a solid plate of sputtering material mounted facing the substrate in the chamber 40, or comprise a layer of sputtering material deposited on the ceiling 50 of the chamber 40. Typical sputtering materials include metals, refractory metals, and semiconductors including, for example, aluminum, aluminum-copper, copper, silicon, titanium, titanium-tungsten, boron, hafnium, tungsten, palladium, titanium nitride, tantalum nitride, or mixtures thereof. Preferably, the sputtering target 60 has a sputtering surface with an area of at least about 50 cm², and more preferably from about 80 to 350 cm². Typically, the sputtering target 60 is disc shaped with a diameter of from about 150 to about 610 mm (6 to about 24 inches), and more typically from about 200 to 360 mm (10 to 14 inches). The thickness of the sputtering target 60 is typically from about 1 mm to 30 mm, and more typically from about 1 to 20 mm. Although preferred configurations are described herein, the sputtering target 60 of the present invention should not be limited to a particular geometrical configuration, and can have other conventional sputtering target shapes as would be obvious to one of ordinary skill in the art.

The sputtering surface of the sputtering target 60 should have a uniform crystalline structure to deposit a uniform and homogeneous sputtered film. This is because the crystallographic orientation of the grains in the sputtering surface affect the distribution of material sputtered from the target 60. Thus, the sputtering surface is preferably etched using an acid etchant, for example nitric acid, hydrofluoric acid, hydrochloric acid, sulfuric acid, acetic acid, phosphoric acid, fluoro-boric acid, or mixtures thereof. Typically, the strength of the acid is from about 1% to about 80% by volume, and more preferably from about 20% to about 60% by volume, as generally described in Metals Handbook, Desk Edition, Ed. by H.E. Boyer and T.L. Gall, Amer. Soc. for Metals (1985) pp.35-52, which is incorporated herein by this reference. Alternatively, the sputtering target surface can be electropolished in an electropolishing bath containing the wet chemical etchant. The sputtering target 60 forms the anode, and a conductive material such as steel or aluminum, forms the cathode. When an electric potential or current is passed through the bath, the surface of the target anode "dissolves" into the etchant thereby polishing the surface of the target 60. The etchant in the electropolishing bath is typically a polishing acid such as hydrofluoric acid, nitric acid, sulfuric acid, fluoro-boric acid, or mixtures thereof. For example, the electroplating bath can comprise 2-2.5% by volume of 48% conc. fluoro-boric acid (HBF₄) in water. The sputtering target 60 is electropolished by passing a current with potential of about 20 Volts DC and a current density of about 0.2 Amps/cm², through the bath, as described in Metals Handbook, Desk Edition, Ed. by H.E. Boyer and T.L. Gall, Amer. Soc. for Metals (1985) pp. 35-51 to 35-52.

In a preferred configuration, the gas distributor 55 and the sputtering target 60 comprise a unitary structure. For example, the sputtering target 60 can comprise a plate covering the housing 127 in the chamber ceiling 50, or bonded on the gas distributor 55. The housing 127 is electrically isolated from the chamber 40 so that the target plate 125 can be electrically biased with respect to the chamber 40 to generate an electric field in the chamber. The sputtering target plate 125 comprises (i) a sputtering surface, and (ii) holes extending through the plate and through the sputtering surface for distributing process gas held within the housing into the chamber. Preferably, the target plate is fabricated in the shape of the showerhead diffuser 125 and/or the shield ring 130, as shown in Figure 2. The sputtering target plate 127 can also comprise a thin plate 125 of sputtering material bonded on the showerhead diffuser 125, the plate 125 having holes 135 therethrough that are aligned with the holes of the gas diffuser 125, so that process gas can flow through the holes.

The holes 135 through the target plate 127 are shaped and sized to (i) uniformly distribute process gas in the chamber 40, and (ii) provide uniform sputtering rates from portions of the sputtering surface adjacent to the holes 135. This feature reduces the non-uniformity in sputtering that can occur because of the holes 135 in the surface of the sputtering target 60. Preferably, the target plate comprises at least about 100 holes, and more preferably from about 500 to about 2000 holes. The holes preferably have small diameters of from about 0.1 to 1 mm to further reduce non-uniformity of sputtering. It has also been discovered that the holes 135 can be shaped and sized to reduce variability in sputtering rates at the portions of the sputtering target surface adjacent to the holes. For example, an outlet edge 140 of the holes 135 can be rounded to a radius of from about 0.25 mm to about 1 mm, so that the outlet edges 140 provide a sputtering surface that changes orientation smoothly without sharp or angular edges. Angular edges can cause the sputtering species that energetically impinge on the target 60 to sputter material off the edge of the holes 135 at sharp angles that can result in non-uniform deposition of sputtered material on the substrate, or cause sputtered material to deposit on and seal off the outlet edges 140 of the holes 135.

In yet another configuration, the sputtering target 60 is fabricated by depositing a thin layer of sputtering material directly on components of the gas distributor 55, such as the gas diffuser 125 and/or the shield ring 130, the layer of sputtering material having the desired sputtering surface area. The sputtering material can be deposited on the gas diffuser 125 by conventional coating processes, including for example, electroplating, sputtering, immersion coating, or chemical vapor deposition. Preferably, electroplating is used to deposit a coating of the sputtering material having a thickness ranging from about 25 microns to about 250 microns (1 to 10 mils), and more typically from 100 microns to 200 microns (4 mils to 8 mils). To ensure adhesion of the electroplated coating, the surface of the gas distributor component is thoroughly cleaned using dilute acid and/or degreasing solvent. In the electroplating process, an electrolyte solution containing copper or aluminum metal ions, for example 1 to 100 gm/liter CuCl₂ aqueous solution, is subjected to a low voltage current between the gas distributor component that serves as a cathode, and an anode made of a conductive material such as stainless steel. The bath can also contain additives for improving conductivity or buffering the solution, such as 1 to 100 ml/liter of sulfuric acid. Conventional electroplating processes and solutions are described in *Modern Electroplating*, edited by F. Lowenheim, 2d Ed., John Wiley & Sons (1963), which is incorporated herein by reference; and vendors suitable for electroplating the components of the present invention include ACTERON, of Redwood City, California, and HAMMON PLATING, of Palo Alto, California.

The other components of the apparatus 35 can be fabricated using conventional casting, molding, and machining techniques, and are typically made from a variety of materials including metals, ceramics, glasses, polymers and composite materials. For example, suitable metals that are used to fabricate the chamber and processing components, include aluminum, stainless steel, and high temperature alloys such as "HASTALLOY" or "INCONEL." Suitable ceramic materials that can be used to fabricate the chamber and components include silicon dioxide, aluminum oxide, silicon nitride, and boron nitride.

The process can be implemented using a computer program product 141 that runs on a conventional computer system comprising a central processor unit (CPU) interconnected to a memory system with peripheral control components, such as for example a 68040 microprocessor, commercially available from Synenergy Microsystems, California. The computer program code can be written in any conventional computer readable programming language such as for example 68000 assembly language, C, C++, or Pascal. Suitable program code is entered into a single file, or multiple files, using a conventional text editor, and stored or embodied in a computer usable medium, such as a memory system of the computer. If the entered code text is in a high level language, the code is compiled, and the resultant compiler code is then linked with an object code of precompiled windows library routines. To execute the linked compiled object code, the system user invokes the object code, causing the computer system to load the code in memory, from which the CPU reads and executes the code to perform the tasks identified in the program.

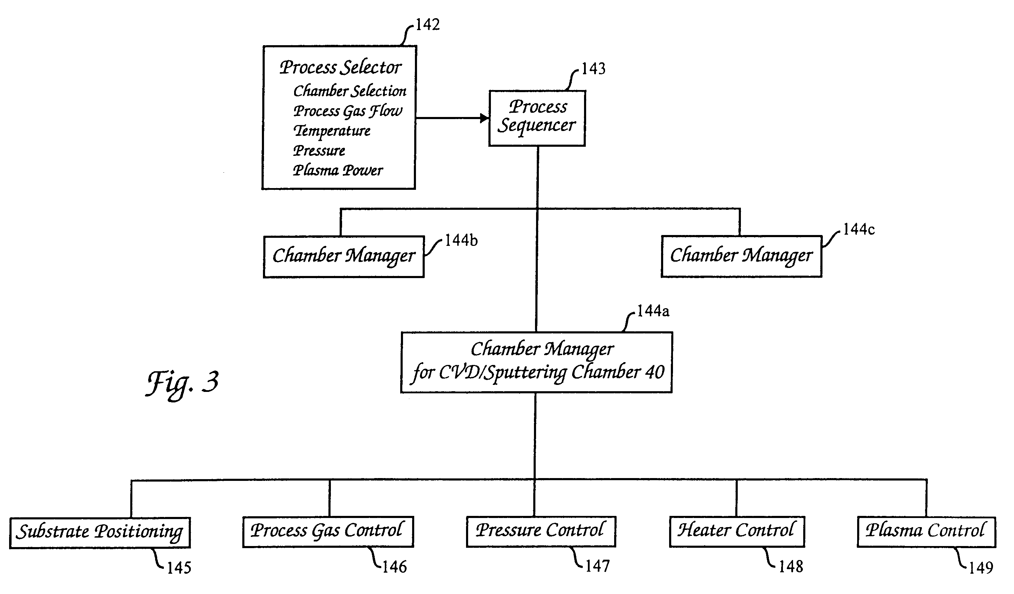

Figure 3 shows an illustrative block diagram of the hierarchical control structure of the computer program 141. A user enters a process set number and process chamber number into a process selector subroutine 142. The process sets are predetermined sets of process parameters necessary to carry out specified processes, and are identified by predefined set numbers. The process selector subroutine 142 identifies (i) the desired process chamber, and (ii) the desired set of process parameters needed to operate the process chamber for performing the desired process. The process parameters relate to process conditions such as, for example, process gas composition and flow rates, temperature, pressure, plasma conditions such as RF bias power levels and magnetic field power levels, cooling gas pressure, and chamber wall temperature.

A process sequencer subroutine 143 comprises program code for accepting the identified process chamber and set of process parameters from the process selector subroutine 142, and for controlling operation of the various process chambers. Multiple users can enter process set numbers and process chamber numbers, or a user can enter multiple process set numbers and process chamber numbers, so the sequencer subroutine 143 operates to schedule the selected processes in the desired sequence. Preferably the sequencer subroutine 143 includes a program code to perform the steps of (i) monitoring the operation of the process chambers to determine if the chambers are being used, (ii) determining what processes are being carried out in the chambers being used, and (iii) executing the desired process based on availability of a process chamber and type of process to be carried out. Conventional methods of monitoring the process chambers can be used, such as polling. When scheduling which process is to be executed, the sequencer subroutine 143 can be designed to take into consideration the present condition of the process chamber being used in comparison with the desired process conditions for a selected process, or the "age" or queuing position of each particular user entered request, or any other relevant factor a system programmer desires to include for determining scheduling priorities.

Once the sequencer subroutine 143 determines which process chamber and process set combination is going to be executed next, the sequencer subroutine 143 causes execution of the process set by passing the particular process set parameters to a chamber manager subroutine 144a-c, each chamber manager subroutine being provided for controlling multiple processing tasks in a corresponding process chamber. The chamber manager subroutines 144a-c perform sequential processing tasks in a particular chamber according to the process set determined by the sequencer subroutine 143. For example, the chamber manager subroutine 144a comprises program code for controlling sputtering and CVD process operations in the process chamber 40. The chamber manager subroutine 144a also controls execution of various chamber component subroutines which control operation of the components of the chamber 40 that are necessary to carry out the selected process set. Examples of chamber component subroutines include the substrate positioning subroutine 145, process gas control subroutine 146, pressure control subroutine 147, heater control subroutine 148, and plasma control subroutine 149. Those having ordinary skill in the art would readily recognize that other chamber control subroutines can be included depending on what processes are desired to be performed in the process chamber 40. In operation, the chamber manager subroutine 144a selectively schedules or calls the process component subroutines in accordance with the particular process set being executed. The chamber manager subroutine 144a schedules the process component subroutines similarly to how the sequencer subroutine 143 schedules which process chamber 40 and process set is to be executed next. Typically, the chamber manager subroutine 144a includes steps of monitoring the various chamber components, determining which components needs to be operated based on the process parameters for the process set to be executed, and causing execution of a chamber component subroutine responsive to the monitoring and determining steps.

Operation of particular chamber component subroutines will now be described. The substrate positioning subroutine 145 comprises program code for controlling chamber components that are used to load the substrate 20 onto the chamber support 65, and optionally to lift the substrate to a desired height in the chamber 40 to control the spacing between the substrate and the gas distributor 55 or sputtering target 60. When a substrate 20 is loaded into the process chamber 40, the substrate support 65 is lowered to receive the substrate, and thereafter, the support is raised to the desired height in the chamber, to maintain the substrate at (i) a first distance or spacing from the gas distributor 55 during the CVD process, and (ii) a second spacing from the sputtering target 60 for the sputtering process. In operation, the substrate positioning subroutine 145 controls movement of the support 65 in response to process set parameters related to the support height that are transferred from the chamber manager subroutine 144a.

The process gas control subroutine 146 has program code for controlling process gas composition and flow rates. Generally, the process gases supply lines for each of the process gases, which include (i) safety shut-off valves (not shown) that can be used to automatically or manually shut off the flow of process gas into the chamber, and (ii) mass flow controllers (also not shown) that measure the flow of gas through the gas supply lines. When toxic gases are used in the process, the several safety shut-off valves are positioned on each gas supply line in conventional configurations. The process gas control subroutine 146 controls the open/close position of the safety shut-off valves, and also ramps up/down the mass flow controllers to obtain the desired gas flow rate. The process gas control subroutine 146 is invoked by the chamber manager subroutine 144a, as are all chamber component subroutines, and receives from the chamber manager subroutine process parameters related to the desired gas flow rates. Typically, the process gas control subroutine 146 operates by opening the gas supply lines, and repeatedly (i) reading the necessary mass flow controllers, (ii) comparing the readings to the desired flow rates received from the chamber manager subroutine 144a, and (iii) adjusting the flow rates of the gas supply lines as necessary. Furthermore, the process gas control subroutine 146 includes steps for monitoring the gas flow rates for unsafe rates, and activating the safety shut-off valves when an unsafe condition is detected.

In some processes, an inert gas such as argon is flowed into the chamber 40 to stabilize the pressure in the chamber before reactive process gases are introduced into the chamber. For these processes, the process gas control subroutine 146 is programmed to include steps for flowing the inert gas into the chamber 40 for an amount of time necessary to stabilize the pressure in the chamber, and then the steps described above would be carried out. Additionally, when a process gas is to be vaporised from a liquid precursor, for example tetraethylorthosilane (TEOS), the process gas control subroutine 146 would be written to include steps for bubbling a delivery gas such as argon through the liquid precursor in a bubbler assembly. For this type of process, the process gas control subroutine 146 regulates the flow of the delivery gas, the pressure in the bubbler, and the bubbler temperature in order to obtain the desired process gas flow rates. As discussed above, the desired process gas flow rates are transferred to the process gas control subroutine 146 as process parameters. Furthermore, the process gas control subroutine 146 includes steps for obtaining the necessary delivery gas flow rate, bubbler pressure, and bubbler temperature for the desired process gas flow rate by accessing a stored table containing the necessary values for a given process gas flow rate. Once the necessary values are obtained, the delivery gas flow rate, bubbler pressure and bubbler temperature are monitored, compared to the necessary values and adjusted accordingly.

The pressure control subroutine 147 comprises program code for controlling the pressure in the chamber 40 by regulating the size of the opening of the throttle valve in the exhaust system 115 of the chamber. The size of the opening of the throttle valve is set to control the chamber pressure to the desired level in relation to the total process gas flow, size of the process chamber, and pumping setpoint pressure for the exhaust system 115. When the pressure control subroutine 147 is invoked, the desired, or target, pressure level is received as a parameter from the chamber manager subroutine 144a. The pressure control subroutine 147 operates to measure the pressure in the chamber 40 by reading one or more conventional pressure nanometers connected to the chamber, compare the measure value(s) to the target pressure, obtain PID (proportional, integral, and differential) values from a stored pressure table corresponding to the target pressure, and adjust the throttle valve according to the PID values obtained from the pressure table. Alternatively, the pressure control subroutine 147 can be written to open or close the throttle valve to a particular opening size to regulate the chamber 40 to the desired pressure.

The heater control subroutine 148 comprises program code for controlling the temperature of the heater 80 that is used to heat the substrate 20. The heater control subroutine 148 is also invoked by the chamber manager subroutine 144a and receives a target, or setpoint, temperature parameter. The heater control subroutine 148 measures the temperature by measuring voltage output of a thermocouple located in a susceptor, compares the measured temperature to the setpoint temperature, and increases or decreases current applied to the heater 80 to obtain the setpoint temperature. The temperature is obtained from the measured voltage by looking up the corresponding temperature in a stored conversion table, or by calculating the temperature using a fourth order polynomial. When radiant lamps are used as the heater 80, the heater control subroutine 148 gradually controls a ramp up/down of current applied to the lamp. The gradual ramp up/down increases the life and reliability of the lamp. Additionally, a built-in fail-safe mode can be included to detect process safety compliance, and can shut down operation of the heater 80 if the process chamber 40 is not properly set up.

The plasma control subroutine 149 comprises program code for setting the RF bias voltage power level applied to the process electrodes in the chamber 40, and optionally, to set the level of the magnetic field generated in the chamber. Similar to the previously described chamber component subroutines, the plasma control subroutine 149 is invoked by the chamber manager subroutine 144a. In operation, the plasma control subroutine 149 applies a current to the plasma generator 116 to form a plasma in the chamber 40. The plasma control subroutine 149 includes steps for reading both "forward" power applied to the plasma generator 116, and "reflected" power flowing through the chamber 40. An excessively high reflected power reading indicates that the plasma has not been ignited, and the plasma control subroutine 149 restarts or shuts down the process. The read power levels are compared against target levels, and the current is adjusted to control the plasma generation. When a magnetic field generator is used, the plasma control subroutine 149 typically includes steps for applying a sinusoidal wave current to the generator to form a rotating magnetic field in the chamber 40. The sinusoidal wave needed to generate a desired magnetic field can be obtained from a stored table of sinusoidal values corresponding to magnetic field strengths, or calculated using a sinusoidal equation.

The process of the present invention will now be illustrated by way of exemplary processes that generally comprises the steps of (i) forming electrically conductive interconnect lines on the substrate, (ii) depositing a first insulator layer on the interconnect lines, (iii) etching holes in the first insulator layer, (iv) depositing layers of metal in the etched holes, (v) heating the substrate to diffuse the different layers of metal into one another to form a homogeneous mixture of metals in the holes, and (vi) depositing additional insulator and metal layers over the filled holes to electrically isolate and electrically connect the conductive metal in the holes.

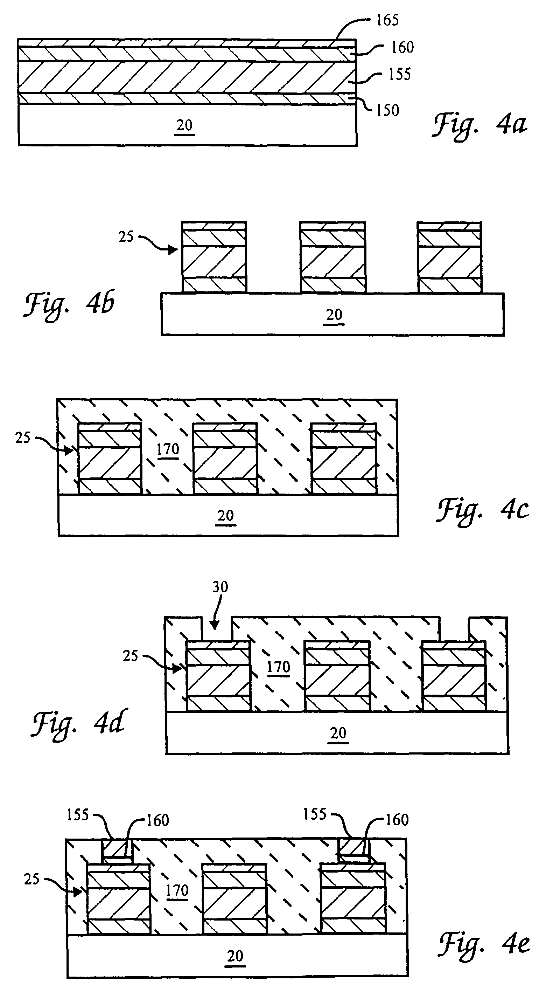

Figures 4a to 4e show schematic views of successive steps of manufacturing a substrate according to the present invention, of which Figures 4a and 4b illustrate the steps for forming interconnect lines on the substrate 20. First, a diffusion barrier layer 150 comprising a refractory metal or a nitride or silicide thereof, such as titanium, tungsten, titanium nitride, molybdenum silicide, titanium silicide, and mixtures thereof, is deposited on the substrate 20 to a thickness of about 50 to 300 nm. The diffusion barrier layer 150 reduces interdiffusion of aluminum and silicon and prevents undesirable reaction at the interface between the interconnects and the substrate.

Thereafter, the apparatus of the present invention is used to deposit an electrically conductive layer of metal on the substrate, using a multistage process that includes CVD and sputtering process stages, performed in a single deposition chamber 40. In a CVD process stage, deposition gas is introduced into the deposition chamber 40 via the gas distributor 55, and the chamber is maintained at process conditions suitable for depositing a first chemical vapor deposited material or layer 155 on the substrate 20. For example, the first chemically vapor deposited material 155 can comprise a layer of aluminum, deposited to a thickness of 300 to 800 nm. Suitable deposition gases for depositing aluminum include dimethyl aluminum hydride (DMAH), tri-isobutyl aluminum, trimethylamine alane, dimethylelthylamine alane, and intermolecular compounds between triethyl aluminum and dimethyl aluminum hydride. The flow rate of the deposition gas is selected to provide a deposition rate of at least 100 A/min, and more preferably at least about 500 A/min. For aluminum deposition using DMAH suitable deposition gas flow rates range from about 100 to about 1000 sccm for the size of the deposition chamber 40 described herein. During the CVD process, the process zone 95 is maintained at a temperature of about 200°C to 300°C, and more typically about 260°C, and the pressure in the process zone 95 is maintained at at least 0.5 Torr, and more preferably from about 1 Torr to about 30 Torr.

Thereafter, in the same chamber 40, a sputtering process is performed to deposit a second sputtered material or layer 160, such as for example a layer of copper, over the chemically vapor deposited material 155, without removing the substrate 20 from the chamber 40. Sputtering process gas, such as inert gas, for example argon or helium, or a reactive gas such as nitrogen, ammonia, methane, or diborane, is introduced into the process zone 95 of the apparatus 35. The volumetric flow rate of the sputtering gas is typically from about 1 to about 200 sccm, for the size of the deposition chamber 40 described herein. The chamber 40 is maintained at a pressure ranging from about 1 mTorr to about 500 mTorr. A plasma is generated in the process zone 95 by electrically biasing the sputtering target 60 using an RF or DC bias, and electrically grounding the support 65 or the chamber walls 45. In the sputtering processes, the sputtering target 60 is bombarded by energetic plasma ions causing sputtered material to be removed from the target 60 and deposited on the substrate 20.

To form a multicomponent aluminum alloy, for example an alloy having a composition of about 95 to 98 wt% aluminum plus 0.5 to 10% copper, the thickness of the deposited aluminum and copper layers should be precisely controlled, so that the amount of each material deposited on the substrate provides the desired wt% ratio in the alloy resulting after diffusion heat treatment of the substrate 20. Thus, the CVD and sputtering process stages are each performed for sufficient period of time that the ratio of the thickness of the sputtered layer 160 deposited on the substrate to the thickness of the chemically vapor deposited layer 155 is from about 0.1:100 to about 1:100. Preferably, the CVD process stage is performed for a sufficient time to deposit the chemically vapor deposited layer 155 to a thickness of at least about 100 nm, and more preferably at least about 300 nm; and the sputtering stage is performed for a sufficient time to deposit the sputtered layer 160 to a thickness of less than about 50 nm, and more preferably less than about 3 nm. These thickness provide the desired ratio of aluminum to copper when these materials are diffused into one another using the heat treatment process described below.

An antireflective layer 165 is then deposited on the substrate 20 to decrease the reflective coefficient of the underlying layers, a suitable antireflective layer 165 comprising TiW in a thickness of 20 to 100 nm, which allows precise patterning of the metal film and also serves to improve the reliability of the interconnect lines 25. Thereafter, the diffusion barrier, aluminum/copper, and antireflective layers are selectively etched to form a lower level of metal interconnect lines 25, as shown in Figure 4b. The interconnect lines 25 are formed by applying a resist layer on the deposited layer, patterning the resist layer using photolithographic methods, and etching the exposed portion of the deposited layers that is not protected by the resist. Etching can be performed by conventional reactive ion etching methods that use halogen-containing gases, such as BCl₃, Cl₂, SF₆, CF₄, CFCl₃, CF₂Cl₂, CF₃Cl, CHF₃, and C₂ClF₅, HF, SiCl₄, NF₃, F₂, and CCl₄, as generally described in S. Wolf and R. N. Tauber, Silicon Processing for the VLSI Era, Vol. I, Chap. 16: Dry Etching for VLSI, Lattice Press, Sunset Beach, California (1986), which is incorporated herein by reference. Residual resist is removed by conventional oxygen plasma ashing methods. Thereafter, a first insulator layer 170 is deposited on, and between, the etched interconnect lines 25 to electrically isolate the interconnect lines from one another, as shown in Figure 4c. The insulator layer 170 can comprise silicon dioxide, PSG, or BPSG, and is deposited by conventional methods to a thickness of about 300 to 1000 nm. Typical chemical vapor deposition processes for depositing insulator layers on a substrate are (i) silicon source gas for example SiH₄ or SiCl₂H₂, and oxygen source gas such as CO₂ and H₂, or N₂O; (ii) a single gas containing both silicon and oxygen such as Si(OC₂H₅)₄, or (iii) gases such as SiH₄ and NH₃ or N₂ for depositing Si₃N₄. Thereafter, a hole 175 such as a via, having a diameter of 0.25 to 1 µm, and more typically about 0.5 µm, is etched in the insulator film 170, as shown in Figure 4d, by conventional RIE etching methods that use fluorine containing gases.

Thereafter, the process of the present invention can be used again to deposit multiple layers of electrically conductive materials in the etched via by successive sputtering and chemical vapor deposition steps. The filled via is used to connect lower levels of devices or interconnect lines to upper levels of interconnect lines on the substrate. In the sputtering stage, the sputtered material 160 is deposited into the vias to a thickness of about 2 nm, as shown in Figure 4e, by the previously described sputtering process. The sputtered material 160, for example copper, is deposited from a copper sputtering target 60 by introducing argon gas into the deposition zone 95, maintaining a pressure of about 1 mTorr to about 500 mTorr, and generating a plasma in by electrically biasing the sputtering target 60 using an RF or DC bias. It has been discovered that a thin layer of sputtered material 160 serves as a nucleation layer to enhance the uniformity and rate of deposition of the subsequent CVD process, thus, it is generally preferred to deposit a thin sputtered layer 160 on the substrate followed by deposition of the chemically vapor deposited material 155.

Thereafter, in the same chamber 40, a chemical vapor deposition process is used to deposit a chemically vapor deposited material 155, such as aluminum, over the sputtered material, without removing the substrate 20 from the chamber 40. The aluminum is deposited to a thickness of about 100 to 1000 nm, as shown in Figure 4e. The aluminum can be deposited on the substrate by flowing dimethyl aluminum hydride (DMAH) into the deposition chamber 40 at a flow rate of from about 100 to about 1000 sccm to provide a deposition rate of 10 to 600 nm/min. The deposition zone 95 is maintained at a temperature of about 200°C to 300°C, and more typically about 260°C, and the pressure in the deposition zone 95 is maintained at at least 0.5 Torr, and preferably from about 1 Torr to about 30 Torr.

After depositing the chemically vapor deposited 155 and sputtered materials 160 on the substrate 20, a further heat treatment diffusion step can be performed to diffuse the chemically vapor deposited and sputtered materials into one another. In this step, the substrate 20 is heated to sufficient temperature, for a sufficient time, to diffuse the two materials 155, 160 into one another to form a substantially uniform mixture of materials. By "substantially uniform" it is meant that the average composition of the mixture of materials within each strata of the diffused layer is between ± 10% of the average composition of the bulk of the diffused layer through its entire thickness. Where Tₘ is the melting temperature of the material having a lower melting point, diffusion temperatures selected to be from about 0.5 Tₘ to 0.8 Tₘ generally provide good diffusion of the two materials into one another. For a mixture of aluminum and copper, Tₘ is the melting point of aluminum at about 500°C to 550°C for diffusing copper and aluminum into one another, and suitable diffusion temperatures are from about 250°C to 440°C. A suitable heat treatment process comprises heating the substrate 20 in flowing nitrogen to a temperature of at least about 250°C, and more preferably from about 300°C to 500°C, and at a chamber pressure of less than about 10 mTorr. The diffusion step is typically carried out for about 0.5 to about 10 minutes, and more typically from 1 to 4 minutes. It is preferred to perform the diffusion step immediately after the sputtering and CVD process stages to avoid diffusion of other deposited materials, such as underlying layer deposits, into the mixture of the chemical vapor deposited and sputtered materials.

Instead of a separate diffusion step, the heat used to decompose the deposition gas during the CVD process, the heat generated during the sputtering process, or in other processes, can also be used to diffuse the chemical vapor deposited and sputtered materials. For example, the substrate 20 is typically heated to a temperature of about 250°C to 350°C during the CVD process, which is a sufficiently high temperature to diffuse copper and aluminum. Also, subsequent substrate processes in which the substrate is heated, such as thermal oxide, dielectric CVD, metal CVD, silicon dioxide CVD, and metal sputtering processes, can also be used to diffuse the two materials into one another. Thus, it is not always necessary to perform the heat treatment diffusion step.

The above-described apparatus and processes have several significant advantages over conventional processes. First, the combined CVD, sputtering, and diffusion heat treatment processes are particularly useful for forming homogeneous mixtures of different materials that are difficult to form using conventional processes. Furthermore, the CVD/sputtering process can be used to conformally deposit material into contact holes or vias at faster deposition rates than conventional processes. Moreover, the ability to perform CVD and sputtering processes in a single chamber prevents formation of native oxide films on the deposited layers when the substrate is transferred from a CVD chamber to a sputtering chamber. The native oxide films reduces interdiffusion of the different materials into one another during subsequent heat treatment processes. Absence of the native oxide layer allows fabrication of novel combinations of materials that can be homogeneously interdiffused into one another.

In the exemplary process, aluminum is deposited by chemical vapor deposition, and copper is sputtered on the substrate 20. However, the CVD and sputtering processes can be performed in any order, and can comprise multiple CVD process stages and multiple sputtering process stages. Generally, however, it is preferred to initially deposit a layer of sputtered material 160 that can serve as a nucleation layer to enhance the uniformity and rate of deposition of the chemically vapor deposited layer 155. Furthermore, although the CVD and sputtering process is described in relation to deposition of aluminum by CVD and the deposition of copper by sputtering, the process of the present invention can also be performed by CVD of copper from copper precursor gases, and sputtering of aluminum from an aluminum sputtering target.

The present process can also be used to deposit many other combinations of different materials such as metals, refractory metals, semiconductors, and dielectrics, including for example, aluminum, copper, silicon, titanium, palladium, hafnium, boron, tungsten, tantalum, or mixtures thereof. Suitable CVD deposition gases for many of these materials include volatile metal alkyl or metal carbonyl precursor gases. For example, chromium can be deposited from chromium carbonyl, cadmium from dimethyl cadmium, and copper from copper carbonyl. Copper can also be deposited using a volatile copper coordination complex such as bis-(1, 1, 1, 5, 5, 5, hexafluoro-2, 4-pentanedionate) copper (2), CuHF, CuCl₂, and Cu(C₅H₇O₂)₂. Thus, the present invention should not be limited to a particular process sequence, or to deposition of the exemplary materials described herein.

### EXAMPLES 1 to 3

The following examples demonstrate the effectiveness of the process of the present invention. However, the apparatus of the present invention can be used in other applications, as would be apparent to those skilled in the art, and the scope of the present invention should not be restricted to the illustrative examples provided herein.

In these examples, a single-wafer deposition chamber, namely a "CENTURA 2195" System CVD equipment commercially available from Applied Materials, Santa Clara, California, and described in Clark, et al., supra, was modified to fabricate the deposition chamber 40 of the present invention. In the apparatus, the gas distributor 55 was coated by an electroplated coating of copper to a thickness of about 50 microns. The electroplated gas distributor 55 was electrically isolated from the deposition chamber 40 to serve as a process electrode.

Silicon substrates 20 having a thickness of about 0.73 mm and a diameter of about 150 mm were used in these examples. The substrates had an insulator layer 170 of silicon dioxide having a thickness of about 100 nm. A diffusion barrier layer 150, comprising 20 nm of titanium and 10 nm titanium nitride, was deposited on the substrate using conventional CVD techniques. Thereafter, vias 30 having a diameter of 0.8 microns were etched through the insulator layer 170.

A substrate 20 was loaded using a mechanical arm into the process zone 95 of the deposition chamber 40, from a load lock area (not shown) in which nitrogen was flowed at a pressure of 7 Torr. The substrate 20 was placed on a resistively heated support 65 in the deposition chamber 40 and heated to a temperature of about 260°C. The substrate 20 typically equilibrated within 60 seconds at a temperature of about 5°C to 20°C lower than the temperature of the support 65. When the substrate 20 achieved equilibrium temperature, the pressure in chamber 40 was established using a flow of non-reactive gases and controlled by a throttle valve on the exhaust system.

In these examples, the copper coating on the gas distributor 50 was sputtered to deposit copper into the etched vias 30. Argon was introduced into the chamber 40 at a flow rate of 15 sccm through the gas distributor 55, and the chamber was maintained at a pressure of about 0.1 Torr. A current of 600 watts power was applied to the unitary structure comprising the gas distributor 55 and sputtering target 60 to generate a plasma from the argon in the chamber 40. The argon plasma sputtered the copper coating to deposit copper on the substrate 20 and in the etched vias. This process was performed for about 60 seconds to deposit a copper layer having a thickness of about 10 nm.

Thereafter, without removing the substrate 20 from the deposition chamber 40, aluminum was deposited on the copper layer by a chemical vapor deposition process performed in the same deposition chamber 40. In this process step, dimethyl aluminum hydride (DMAH) deposition gas was introduced into the chamber 40 at a flow rate of about 100 sccm through the gas distributor 55. The deposition chamber 40 was maintained at a pressure of 25 Torr, and a temperature of 260°C, for about 30 seconds to deposit an aluminum layer having a thickness of about 1000 nm.

Several substrates were processed as described above, and additional substrates were processed using the same process conditions, but with the order of the steps reversed, *i.e*., aluminum was first deposited by CVD in the vias 30, and thereafter a copper layer was sputtered over the aluminum layer. After the deposition processes, diffusion processes were conducted in which the substrates were heated at different temperatures to study the diffusion of copper and aluminum into one another. The substrates were annealed at temperatures of 170°C, 250°C, and 300°C, each diffusion step being performed for about 5 minutes.

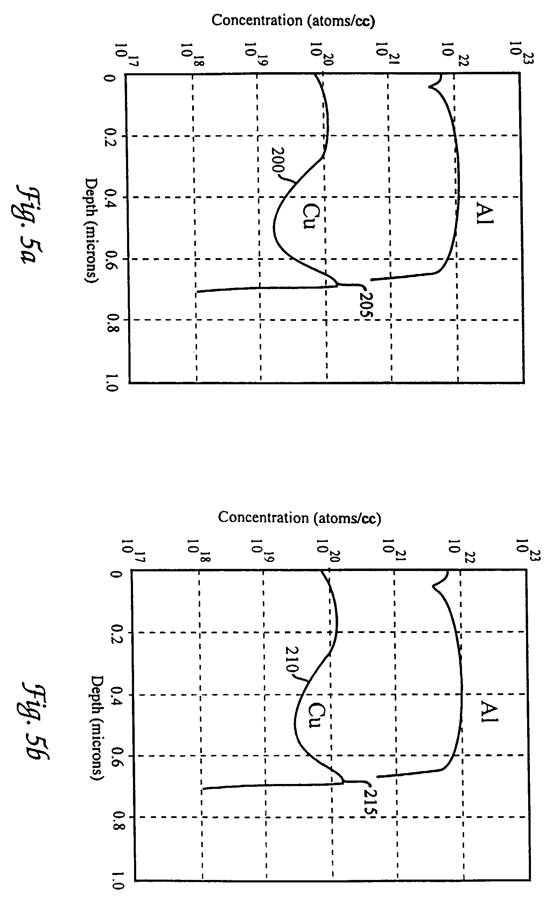

Figures 5a to 5c show secondary ion mass spectrographs (SIMS) of the mass concentration of copper and aluminum layers on the substrate, measured using conventional SIMS equipment. Ion implanted standards with known quantities of copper and aluminum were used to quantify the levels of copper and aluminum in the SIMS profiles. In these figures, the y-axis shows the concentration of atoms, and the x-axis shows the depth of the measurement through the thickness of the aluminum and copper layers. The distribution of copper through the depth of the aluminum layer is uniform when the copper concentration line is substantially planar.

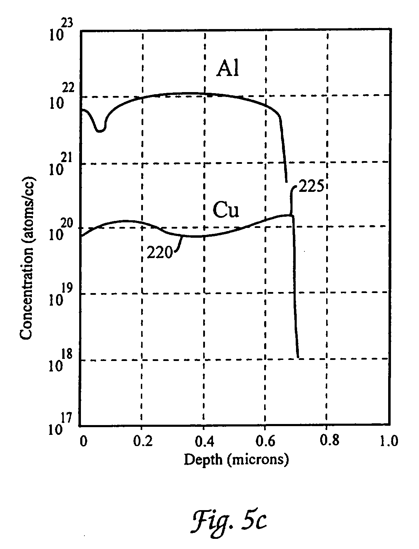

Figure 5a shows that after annealing at 170°C, there is still a large deficiency of copper through the thickness of the film. The concentration of copper from a depth of 0.2 to 0.6 microns in the deposited aluminum layer is excessively low as evidenced by the sharp dip in the copper concentration curve between the points 200 and 205. After annealing at 250°C, as shown in Figure 5b, the concentration of copper from a depth of 0.2 to 0.6 microns in the aluminum layer although more uniform, is still low, as evidenced by the more moderate dip in the copper concentration curve between the points 210 and 215. After annealing at 300°C, the concentration of copper through the thickness of the film becomes substantially uniform, as shown in Figure 5c, and the concentration of copper through the depth of 0.2 to 0.6 microns in the aluminum layer exhibited only a gentle reduction between the points 220 and 225. Thus, a diffusion temperature of at least about 250°C, and more preferably at least about 300°C, is needed to provide optimal diffusion of the copper and aluminum layers into one another.

The apparatus 35 of the present invention has several advantages. First, performing both CVD and sputtering operations in a single deposition chamber provides higher substrate yields and increased process throughput. Because the substrate does not have to be moved from one chamber to another, the transportation step is eliminated, thereby increasing the throughput of the apparatus. Also, during transportation of the substrate, the substrate can be damaged, or impurities can deposit on the substrate. Thus, elimination of transportation step increases the yield of chips from the substrate. These features of the present invention provide numerous applications for a variety of semiconductor fabrication processes.

Furthermore, the combined CVD and sputtering process allows deposition of a variety of materials, including deposition of multicomponent alloys and multiple layers of different materials on the substrate. The ability to perform a combination CVD and sputtering process is particularly advantageous for deposition of complex multicomponent materials and layers with different materials. The apparatus and method of the present invention also provides more conformal deposition of material onto the substrate, particularly into the high aspect ratio contact holes or vias in the substrate. Moreover, the heat treatment diffusion process is useful for forming homogeneous mixtures of different materials. Use of a single deposition chamber to deposit different materials over one another, allows the different materials to be homogeneously diffused into one another, without the formation of a native oxide layer between the materials that hinders interdiffusion of the materials. This allows fabrication of novel combinations of interdiffused materials using a single process chamber.

The present invention has been described in considerable detail with reference to certain preferred versions thereof. However, other versions are possible. For example, the present invention can be used to deposit many different materials on the substrate, and is not limited to processing of semiconductor substrates. Therefore the spirit and scope of the appended claims should not be limited to the description of the preferred versions contained herein.

## Claims

1. Chemical vapor deposition and sputtering method for depositing material on a substrate, the method comprising the steps of:
(a) placing the substrate in a process zone comprising (i) a gas distributor for distributing process gas in the process zone, and (ii) a sputtering target facing the substrate;
(b) in a CVD process stage, (i) introducing deposition gas into the process zone, and (ii) maintaining process conditions suitable for depositing a first material on the substrate by decomposition of the deposition gas; and
(c) in a sputtering process stage, performed before or after the CVD process stage, (i) introducing sputtering gas in the process zone, and (ii) forming a plasma from the sputtering gas to deposit a second material on the substrate by sputtering the target.

2. Method according to claim 1, wherein the deposition gas comprises a material selected from the group consisting of aluminum, copper, silicon, titanium, palladium, hafnium, boron, tungsten or mixtures thereof.

3. Method according to claim 1, further comprising the step of heating the substrate to temperatures sufficient to diffuse the CVD and sputtered materials into one another to form a substantially homogeneous diffusion mixture.

4. Method according to any of the claims 1 to 3, wherein the sputtering process is performed prior to the CVD process, and wherein
(a) in the sputtering process stage a sputtered nucleation layer is formed on the substrate by sputtering the target; and
(b) in the CVD process stage a chemically vapor deposited layer is deposited on the sputtered nucleation layer.

5. Computer program product for operating a process chamber according to the method according to one of the claims 1 to 4 to deposit material on a substrate by chemical vapor deposition and sputtering processes, the computer program product comprising a computer usable medium having computer readable program code means embodied in the medium, the computer program comprising:
(a) a substrate positioning subroutine or positioning program code means for positioning the substrate in the process chamber;
(b) a process gas control subroutine or process program code means for operating the process chamber in (i) a CVD deposition mode in which deposition gas is introduced into process chamber, and (ii) a sputtering gas mode in which sputtering gas is introduced into the process chamber.

6. Computer program product according to claim 5, further comprising a plasma control subroutine for operating the process chamber in (i) a CVD plasma mode in which a plasma is formed from the deposition gas to deposit CVD material on the substrate by chemical vapor deposition, and (ii) a sputtering plasma mode in which a plasma is formed from sputtering gas to deposit sputtered material on the substrate by sputtering the target.

7. Computer program product according to claim 5 or 6, further comprising a heater control subroutine for operating a heater for heating the substrate to temperatures sufficient to diffuse the CVD and sputtered materials into one another to form a substantially homogeneous diffusion mixture.

8. Deposition chamber apparatus for depositing material on a substrate by chemical vapor deposition and sputtering processes according to any of the claims 1 to 4, the deposition chamber comprising:
(a) chemically vapor deposition means for depositing a first material on the substrate by a chemical vapor deposition process; and
(b) sputtering means for depositing a second material on the substrate by a sputtering process.

9. Apparatus according to claim 8, wherein the chemically vapor deposition means comprises a gas distributor for distributing deposition gas in the chamber, the deposition gas capable of depositing the first material on the substrate.

10. Apparatus according to claim 8, wherein the sputtering means comprises:
(a) a sputtering target;
(b) a gas distributor for distributing sputtering gas in the chamber; and
(c) a plasma generator for generating a plasma from the sputtering gas for sputtering the target.

11. Apparatus according to claim 8, wherein the chemically vapor deposition means and the sputtering means comprise a unitary structure including:
(a) a housing for holding process gas therein; and
(b) a sputtering target plate on the housing, the target plate comprising (i) a sputtering surface comprising sputtering material, and (ii) holes extending through the plate and sputtering surface.

12. Apparatus according to claim 11, wherein the housing is electrically isolated from the process chamber so that the target plate of the housing can be electrically biased with respect to the chamber, to form an electric field that generates a plasma for sputtering material from the sputtering surface of the target plate.

13. Sputtering target apparatus capable of serving as a process gas distributor in a process chamber, the sputtering target comprising a plate having:
(a) a sputtering surface comprising sputtering material; and
(b) holes extending through the plate and sputtering surface, the holes shaped and sized to (i) uniformly distribute process gas into the process chamber, and (ii) reduce variability in sputtering rates at portions of the sputtering surface adjacent to the holes.

14. Apparatus according to claim 13, wherein the plate is shaped and sized to be mounted on a housing in a process chamber, the housing capable of holding process gas therein, and the housing being electrically isolated from the process chamber so that the plate can be electrically biased with respect to the chamber to form an electric field that generates a plasma for sputtering the target plate.

15. Apparatus according to claim 11 or 13, wherein the holes in the target plate are shaped and sized to (i) uniformly distribute process gas in the chamber, and (ii) provide uniform sputtering rates from portions of the sputtering surface adjacent to the holes the holes shaped and sized to uniformly distribute process gas from the housing into the process chamber, and reduce variability in sputtering rates at portions of the sputtering surface adjacent to the holes

16. Apparatus according to any of the claims 10 to 25, wherein the sputtering surface comprises a sputtering material selected from the group consisting of aluminum, copper, silicon, titanium, palladium, hafnium, boron, tungsten, tantalum, and mixtures thereof.

17. Apparatus according to any of the claims 13 to 16, wherein the sputtering surface is chemically etched to provide uniform sputtering rates.

18. Apparatus according to any of the claims 13 to 17, further comprising a heater for heating the substrate to temperatures sufficiently high to form a substantially homogeneous diffusion mixture of the CVD and sputtered materials.

19. Apparatus according to any of the claims 8 to 18, wherein the deposition gas comprises a material selected from the group consisting of metals, refractory metals, semiconductors, and dielectrics.
